# EUROPÄISCHE PATENTSCHRIFT

(11) **EP 4 401 318 B1**
(45) Veröffentlichungstag und Bekanntmachung des Hinweises auf die Patenterteilung: **05.03.2025**
(21) Anmeldenummer: 23151753.3
(22) Anmeldetag: 16.01.2023
(51) Int. Cl.: H03M 1/12

(54) **STROMRICHTER UND TRACESYSTEM FÜR EINEN STROMRICHTER**
POWER CONVERTER AND TRACE SYSTEM FOR A POWER CONVERTER
CONVERTISSEUR DE PUISSANCE ET SYSTÈME DE TRACE POUR CONVERTISSEUR DE PUISSANCE

(43) Veröffentlichungstag der Anmeldung: 17.07.2024
(73) Patentinhaber: Siemens Aktiengesellschaft, 80333 München (DE)
(72) Erfinder: SCHMITT, Regina, 91056 Erlangen (DE); KERPEN, Heinz, 91074 Herzogenaurach (DE); IVCHENKO, Yuriy, 91325 Adelsdorf (DE); SIKLÓS, Jácint Ervin, 7261 Taszár (HU)
(74) Vertreter: Siemens Patent Attorneys

(56) Entgegenhaltungen:
- EP-A1- 3 687 055
- DE-A1- 102020 211 656

## Beschreibung

Die Erfindung betrifft einen Stromrichter und ein Tracesystem zum Erfassen und Auswerten von Trace-Signalen eines Stromrichters.

Beispielsweise wird mit dem Stromrichter eine Versorgungsspannung für einen Elektromotor erzeugt. Alternativ wird mit dem Stromrichter beispielsweise eine Spannung für eine Elektroenergieübertragung umgewandelt.

Um die Funktion und das Verhalten eines Stromrichters zu überwachen, werden so genannte Traces aufgezeichnet und ausgewertet. Ein Trace umfasst zeitlich aufeinander folgende Trace-Signale. Trace-Signale sind beispielsweise Soll- und Istwerte von dem Stromrichter erzeugter Ströme und Spannungen oder anderer Größen, die zur Steuerung des Stromrichters verwendet werden wie einer Drehzahl oder eines Drehmoments eines von dem Stromrichter versorgten Elektromotors, oder auch Werte anderer Betriebszustandsgrößen wie einer Betriebstemperatur des Stromrichters oder einer mit ihm betriebenen Vorrichtung, beispielsweise eines Elektromotors. Trace-Signale können darüber hinaus auch binäre Signale sein, beispielsweise EIN-/AUS-Kommandos über die digitalen Eingänge des Stromrichters oder interne Statussignale des Stromrichters, beispielsweise aus seiner internen Ablaufsteuerung. Die Größen, für die bei einem Trace Trace-Signale aufgezeichnet werden, werden hier als Parameter des Trace bezeichnet. Insbesondere kann ein Trace also verschiedene Parameter aufweisen, so dass bei dem Trace verschiedenartige Trace-Signale aufgezeichnet werden. Dadurch können beispielsweise das Zusammenwirken und Abhängigkeiten verschiedenartiger Trace-Signale untersucht werden.

Bisher erfolgt die Konfiguration von Traces sowie deren Auswertung und grafische Darstellung in einem Engineeringsystem, das eigens installiert werden muss und in der Regel an ein bestimmtes Betriebssystem gebunden ist. Dokument EP3687055 A1 offenbart einen Stromrichter mit Tracemodul, das eingerichtet ist, Trace-Signale gemäß einer Trace-Konfiguration aufzuzeichnen und zu speichern, wobei jedoch nur unterschiedliche Trace-Konfigurationen des Abtast-Zyklus gewählt werden, die auf Grundlage von erkannten Situationen gewählt werden.

Der Erfindung liegt die Aufgabe zugrunde, einen hinsichtlich der Erfassung und Auswertung von Trace-Signalen verbesserten Stromrichter und ein verbessertes Tracesystem zum Erfassen und Auswerten von Trace-Signalen eines Stromrichters anzugeben.

Die Aufgabe wird erfindungsgemäß durch einen Stromrichter mit den Merkmalen des Anspruchs 1 und durch ein Tracesystem mit den Merkmalen des Anspruchs 9 gelöst.

Vorteilhafte Ausgestaltungen der Erfindung sind Gegenstand der Unteransprüche.

Ein erfindungsgemäßer Stromrichter umfasst
- ein Tracemodul, das eingerichtet ist, Trace-Signale gemäß einer Trace-Konfiguration aufzuzeichnen,
- eine Speichereinheit, die eingerichtet ist, von dem Tracemodul aufgezeichnete Trace-Signale zu speichern, und
- einen Webserver, der eingerichtet ist, die Erstellung der Trace-Konfiguration über einen Web-Client zu ermöglichen und dem Web-Client die von der Speichereinheit gespeicherten Trace-Signale bereitzustellen,
- wobei die Trace-Konfiguration für jede Art aufzuzeichnender Trace-Signale eine Abtastrate für die Aufzeichnung der Trace-Signale spezifiziert.

Ein erfindungsgemäßer Stromrichter ermöglicht durch den integrierten Webserver die Konfiguration der in einem Trace aufzuzeichnenden Trace-Signale sowie die grafische Darstellung der Trace-Signale durch einen Web-Client, mit dem der Webserver kommuniziert. Dies ermöglicht einem Inbetriebnehmer des Stromrichters sowie dem Service-Personal eine detaillierte Analyse der Vorgänge im Stromrichter im Fehlerfall, ohne dass ein Engineeringsystem installiert werden muss. Durch die Webserver-Client Architektur kann jedes Endgerät mit einem Webbrowser zur Darstellung der Trace-Signale verwendet werden. Dadurch ermöglicht die Erfindung die Analyse von Trace-Signalen unabhängig von einem Betriebssystem oder Gerät. Beispielsweise ist die Analyse von Trace-Signalen durch die Erfindung auch auf mobilen Endgeräten wie Tablets oder Smartphones möglich. Die Spezifikation von Abtastraten für die Aufzeichnung der Trace-Signale, wobei für verschiedenartige Trace-Signale unterschiedliche Abtastraten vorgegeben werden können, ermöglicht ferner eine Darstellung der zeitlichen Verläufe von Trace-Signalen, ohne die Trace-Signale beispielsweise mit Zeitstempeln speichern zu müssen.

Bei einer Ausgestaltung des erfindungsgemäßen Stromrichters ist der Webserver eingerichtet, Presets für verschiedene Trace-Konfigurationen bereitzustellen, die über den Web-Client auswählbar sind. Dabei kann eine Auswahl von Parametern eines von dem Webserver bereitgestellten Presets über den Web-Client änderbar sein.

Durch die Bereitstellung von Presets wird dem Anwender die Konfiguration von Traces erleichtert. Außerdem wird die Gefahr der Erstellung fehlerhafter Konfigurationen von Traces reduziert. Die Änderbarkeit einer Auswahl von Parametern eines von dem Webserver bereitgestellten Presets über den Web-Client erhöht vorteilhaft die Flexibilität der Konfiguration von Traces.

Bei einer weiteren Ausgestaltung des erfindungsgemäßen Stromrichters ist der Webserver eingerichtet, die Trace-Konfiguration zu exportieren. Dadurch kann die Trace-Konfiguration auch für andere Stromrichter verwendet werden.

Bei einer weiteren Ausgestaltung des erfindungsgemäßen Stromrichters ist der Webserver eingerichtet, eine Trace-Konfiguration und/oder ein Preset zu importieren. Dies ermöglicht beispielsweise die Erstellung einer Trace-Konfiguration in einem Engineeringsystem und die Bereitstellung dieser Trace-Konfiguration über den Webserver.

Bei einer weiteren Ausgestaltung des erfindungsgemäßen Stromrichters spezifiziert die Trace-Konfiguration die aufzuzeichnenden Trace-Signale und eine Triggerbedingung für den Beginn der Aufzeichnung der Trace-Signale und/oder eine Aufzeichnungsdauer der Aufzeichnung der Trace-Signale. Eine Triggerbedingung ist beispielsweise das Überschreiten oder Unterschreiten eines Schwellenwerts durch ein Trace-Signal oder das Auftreten eines Alarms oder einer Meldung. Durch derartige Triggerbedingungen kann die Aufzeichnung von Traces an bestimmte, beispielsweise kritische oder fehlerhafte, Betriebszustände des Stromrichters gebunden werden.

Eine weitere Ausgestaltung des erfindungsgemäßen Stromrichters umfasst einen Kurzzeitspeicher, in dem von dem Tracemodul aufgezeichnete Trace-Signale fortlaufend kurzzeitig gespeichert werden. In der Trace-Konfiguration spezifizierte Trace-Signale, die während einer in der Trace-Konfiguration vorgebbaren Pretrigger-Zeitdauer vor dem Eintreten der Triggerbedingung in dem Kurzzeitspeicher gespeichert wurden, werden zusätzlich zu den ab Eintreten der Triggerbedingung gemäß der Trace-Konfiguration aufzuzeichnenden Trace-Signalen mit der Speichereinheit gespeichert.

Die vorgenannte Ausgestaltung des erfindungsgemäßen Stromrichters ermöglicht es, auch Trace-Signale in ein Trace zu übernehmen, die kurz vor dem Eintreten einer Triggerbedingung in dem Kurzzeitspeicher gespeichert wurden. Dadurch können beispielsweise Hinweise auf mögliche Ursachen für einen kritischen oder fehlerhaften Betriebszustand des Stromrichters, der durch die Triggerbedingung charakterisiert ist, erhalten werden.

Ein erfindungsgemäßes Tracesystem zum Erfassen und Auswerten von Trace-Signalen eines Stromrichters umfasst
- ein in den Stromrichter integriertes Tracemodul, das eingerichtet ist, Trace-Signale gemäß einer Trace-Konfiguration aufzuzeichnen,
- eine in den Stromrichter integrierte Speichereinheit, die eingerichtet ist, von dem Tracemodul aufgezeichnete Trace-Signale zu speichern,
- einen in den Stromrichter integrierten Webserver und
- einen Web-Client, wobei
- der Webserver eingerichtet ist, die Erstellung der Trace-Konfiguration über den Web-Client zu ermöglichen und dem Web-Client die von der Speichereinheit gespeicherten Trace-Signale bereitzustellen,
- der Web-Client eine grafische Benutzerschnittstelle zum Erstellen der Trace-Konfiguration und zum grafischen Darstellen der Trace-Signale bereitstellt
- und die Trace-Konfiguration für jede Art aufzuzeichnender Trace-Signale eine Abtastrate für die Aufzeichnung der Trace-Signale spezifiziert.

Die Vorteile eines erfindungsgemäßen Tracesystems entsprechen den oben genannten Vorteilen eines erfindungsgemäßen Stromrichters.

Bei einer Ausgestaltung des erfindungsgemäßen Tracesystems ist der Web-Client eingerichtet, zeitliche Verläufe der von dem Tracemodul aufgezeichneten Trace-Signale grafisch darzustellen. Insbesondere kann der Web-Client eingerichtet sein, zeitliche Verläufe verschiedenartiger von dem Tracemodul aufgezeichneter Trace-Signale gemeinsam grafisch darzustellen. Dadurch können vorteilhaft zeitliche Verläufe verschiedenartiger Trace-Signale verglichen und gemeinsam analysiert werden.

Bei einer weiteren Ausgestaltung des erfindungsgemäßen Tracesystems ist der Web-Client eingerichtet, zeitliche Verläufe verschiedenartiger Trace-Signale verschiedenfarbig darzustellen. Dadurch wird vorteilhaft die Übersichtlichkeit der Darstellung verschiedenartiger Trace-Signale erhöht, insbesondere wenn mehrere verschiedenartige Trace-Signale gemeinsam dargestellt werden.

Bei einer weiteren Ausgestaltung des erfindungsgemäßen Tracesystems ermöglicht der Web-Client Änderungen der grafischen Darstellung zeitlicher Verläufe verschiedenartiger Trace-Signale unabhängig voneinander durch horizontale und/oder vertikale Verschiebungen und/oder durch Skalierungen. Dies ermöglicht vorteilhaft eine Verbesserung der Vergleichbarkeit verschiedenartiger Trace-Signale.

Bei einer weiteren Ausgestaltung des erfindungsgemäßen Tracesystems ermöglicht der Web-Client die Einblendung horizontaler und/oder vertikaler Mess-Cursor in die grafische Darstellung zeitlicher Verläufe der Trace-Signale. Dies ermöglicht vorteilhaft eine genaue Analyse der Trace-Signale.

Bei einer weiteren Ausgestaltung des erfindungsgemäßen Tracesystems sind aufgezeichnete Trace-Signale und/oder deren grafische Darstellung vom Web-Client exportierbar. Dadurch können die Trace-Signale und/oder deren grafische Darstellung zu Dokumentations- oder Analysezwecken über den Web-Client anderen Systemen verfügbar gemacht werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockdiagramm eines Ausführungsbeispiels eines Tracesystems,
FIG 2 eine Anzeige einer grafischen Benutzerschnittstelle für die Erstellung einer Trace-Konfiguration,
FIG 3 eine Anzeige einer grafischen Benutzerschnittstelle für die grafische Darstellung von Trace-Signalen.

Einander entsprechende Teile sind in den Figuren mit denselben Bezugszeichen versehen.

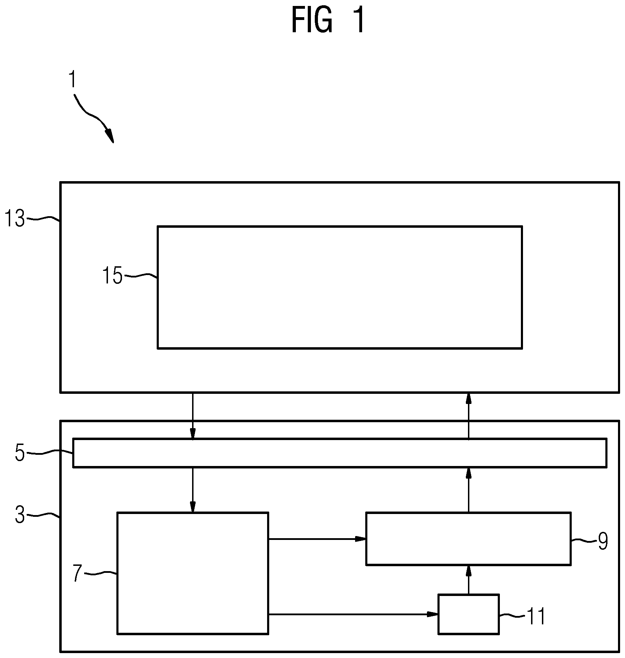

Figur 1 (FIG 1) zeigt ein Blockdiagramm eines Ausführungsbeispiels eines erfindungsgemäßen Tracesystems 1 zum Erfassen und Auswerten von Trace-Signalen eines Stromrichters 3. Das Tracesystem 1 umfasst einen Webserver 5, ein Tracemodul 7, eine Speichereinheit 9, einen Kurzzeitspeicher 11 und einen Web-Client 13. Der Webserver 5, das Tracemodul 7, die Speichereinheit 9 und der Kurzzeitspeicher 11 sind in den Stromrichter 3 integriert. Der Stromrichter 3 mit dem Webserver 5, dem Tracemodul 7, der Speichereinheit 9 und dem Kurzzeitspeicher 11 bilden ein Ausführungsbeispiel eines erfindungsgemäßen Stromrichters.

Das Tracemodul 7 ist eingerichtet, Trace-Signale gemäß einer Trace-Konfiguration aufzuzeichnen. Die Trace-Konfiguration spezifiziert die aufzuzeichnenden Trace-Signale und für jede Art aufzuzeichnender Trace-Signale eine Abtastrate für die Aufzeichnung der Trace-Signale. Ferner spezifiziert die Trace-Konfiguration gegebenenfalls eine Triggerbedingung für den Beginn der Aufzeichnung der Trace-Signale, eine Aufzeichnungsdauer der Aufzeichnung der Trace-Signale und eine Pretrigger-Zeitdauer.

Aufzuzeichnende Trace-Signale sind beispielsweise Soll- und Istwerte von dem Stromrichter 3 erzeugter Ströme und Spannungen oder anderer Größen, die zur Steuerung des Stromrichters 3 verwendet werden wie einer Drehzahl oder eines Drehmoments eines von dem Stromrichter 3 versorgten Elektromotors, oder auch Werte anderer Betriebszustandsgrößen wie einer Betriebstemperatur des Stromrichters 3 oder einer mit ihm betriebenen Vorrichtung, beispielsweise eines Elektromotors. Aufzuzeichnende Trace-Signale können darüber hinaus auch binäre Signale sein, beispielsweise EIN-/AUS-Kommandos über die digitalen Eingänge des Stromrichters 3 oder interne Statussignale des Stromrichters 3, beispielsweise aus seiner internen Ablaufsteuerung.

Eine Triggerbedingung ist beispielsweise das Überschreiten oder Unterschreiten eines Schwellenwerts durch ein Trace-Signal oder das Auftreten eines Alarms oder einer Meldung. Statt durch eine Triggerbedingung kann die Aufzeichnung der Trace-Signale auch manuell oder zeitgesteuert gestartet werden. Die Pretrigger-Zeitdauer wird unten im Zusammenhang mit dem Kurzzeitspeicher 11 erklärt.

Die Speichereinheit 9 ist eingerichtet, von dem Tracemodul 7 aufgezeichnete Trace-Signale zu speichern. Die Speichereinheit 9 ist beispielsweise als ein Ringpuffer ausgebildet.

Der Kurzzeitspeicher 11 ist eingerichtet, von dem Tracemodul 7 aufgezeichnete Trace-Signale fortlaufend kurzzeitig zu speichern. Wenn in der in der Trace-Konfiguration eine Triggerbedingung und eine Pretrigger-Zeitdauer spezifiziert sind, werden in der Trace-Konfiguration spezifizierte Trace-Signale, die während der Pretrigger-Zeitdauer vor dem Eintreten der Triggerbedingung in dem Kurzzeitspeicher 11 gespeichert wurden, mit der Speichereinheit 9 zusätzlich zu den ab Eintreten der Triggerbedingung gemäß der Trace-Konfiguration aufzuzeichnenden Trace-Signalen gespeichert.

Der Webserver 5 ist eingerichtet, die Erstellung der Trace-Konfiguration über den Web-Client 13 zu ermöglichen und dem Web-Client 13 die von der Speichereinheit 9 gespeicherten Trace-Signale bereitzustellen.

Insbesondere ist der Webserver 5 eingerichtet, Presets für verschiedene Trace-Konfigurationen bereitzustellen, die über den Web-Client 13 auswählbar sind. Beispielsweise spezifiziert ein Preset die Parameter eines Trace und somit die aufzuzeichnenden Trace-Signale, für jeden Parameter die Abtastrate, mit der die zugehörigen Trace-Signale aufzuzeichnen sind, die Triggerbedingung und die Aufzeichnungsdauer der Aufzeichnung der Trace-Signale. Dabei kann eine Auswahl von Parametern eines von dem Webserver 5 bereitgestellten Presets über den Web-Client 13 änderbar sein. Beispielsweise können Parameter ausgewählt werden, die mit einem Attribut versehen sind, das sie als für eine Trace-Konfiguration freigegeben kennzeichnet.

Der Webserver 5 kann ferner eingerichtet sein, eine Trace-Konfiguration zu exportieren und/oder eine Trace-Konfiguration und/oder ein Preset zu importieren.

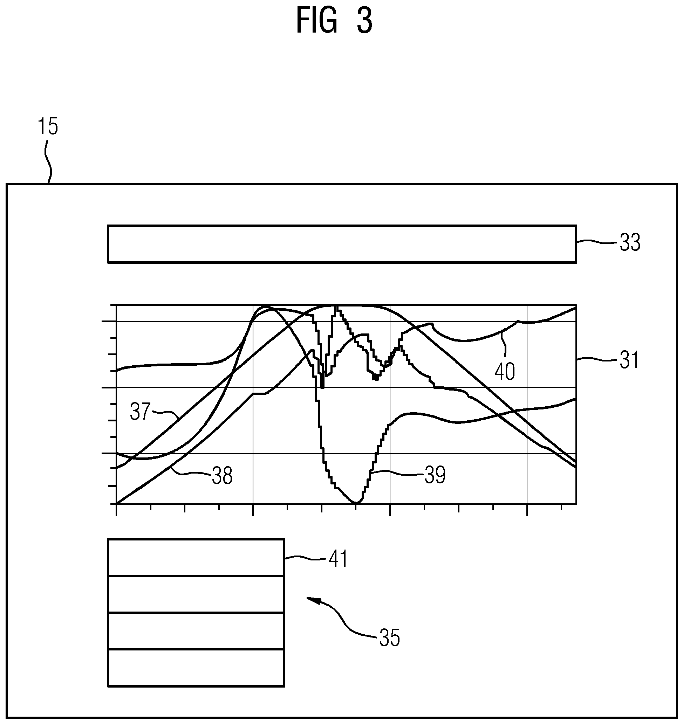

Der Web-Client 13 stellt eine grafische Benutzerschnittstelle 15 zum Erstellen der Trace-Konfiguration und zum grafischen Darstellen der Trace-Signale bereit. Dabei ist der Web-Client 13 eingerichtet, zeitliche Verläufe 37 bis 40 (siehe Figur 3) der von dem Tracemodul 7 aufgezeichneten Trace-Signale grafisch darzustellen.

Ferner ermöglicht der Web-Client 13 Änderungen der grafischen Darstellung zeitlicher Verläufe 37 bis 40 verschiedenartiger Trace-Signale durch horizontale und/oder vertikale Verschiebungen und/oder durch Skalierungen einzelner zeitlicher Verläufe 37 bis 40 sowie durch Zoomen der Darstellung.

Ferner ermöglicht der Web-Client 13 die Einblendung horizontaler und/oder vertikaler Mess-Cursor in die grafische Darstellung zeitlicher Verläufe 37 bis 40 der Trace-Signale.

Außerdem ermöglicht der Web-Client 13, aufgezeichnete Trace-Signale und/oder deren grafische Darstellung zu exportieren.

Der Web-Client 13 ist beispielsweise als ein Computerprogramm, beispielsweise als ein Webbrowser, ausgeführt, das auf verschiedenen Endgeräten, beispielsweise auf einem Personal Computer, einem Tablet und einem Smartphone, ausführbar ist. Der Datentransfer zwischen dem Webserver 5 und dem Web-Client 13 erfolgt beispielsweise gemäß dem Hypertext-Übertragungsprotokoll (http = Abkürzung für hypertext transfer protocol) oder dem sicheren Hypertext-Übertragungsprotokoll (https = Abkürzung für hypertext transfer protocol secure).

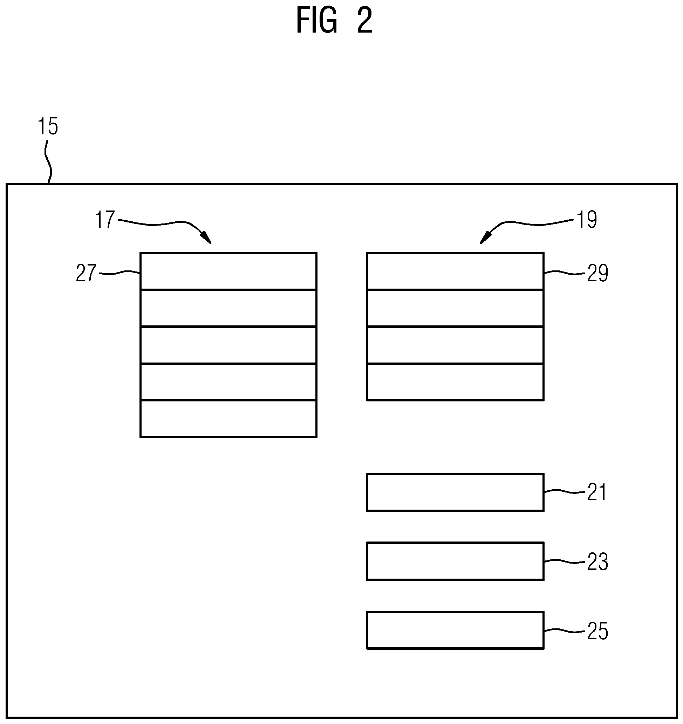

Figur 2 (FIG 2) zeigt beispielhaft eine Anzeige der grafischen Benutzerschnittstelle 15 für die Erstellung einer Trace-Konfiguration. Auf der grafischen Benutzerschnittstelle 15 werden dabei beispielsweise ein Auswahlfeld 17, ein Parameterfeld 19, ein Aufnahmefeld 21, ein Triggerfeld 23 und eine Aktivierungsschaltfläche 25 dargestellt. Das Auswahlfeld 17 weist mehrere Auswahlschaltflächen 27 auf, über die jeweils eine Trace-Konfiguration, das heißt ein Preset, auswählbar ist. In dem Parameterfeld 19 werden für eine ausgewählte Trace-Konfiguration die Parameter der Trace-Konfiguration in Form einer Liste mit Listeneinträgen 29 angezeigt. In dem Aufnahmefeld 21 wird die Aufzeichnungsdauer für die Aufzeichnung von Trace-Signalen der ausgewählten Trace-Konfiguration angezeigt. In dem Triggerfeld 23 wird die Triggerbedingung für den Beginn der Aufzeichnung von Trace-Signalen der ausgewählten Trace-Konfiguration angezeigt. Mit der Aktivierungsschaltfläche 25 kann die Ausführung der ausgewählten Trace-Konfiguration gestartet werden.

Figur 3 (FIG 3) zeigt beispielhaft eine Anzeige der grafischen Benutzerschnittstelle 15 für die grafische Darstellung der Trace-Signale eines Trace, der gemäß einer Trace-Konfiguration ausgeführt wurde. Auf der grafischen Benutzerschnittstelle 15 werden dabei beispielsweise ein Darstellungsfeld 31, eine Menüleiste 33 und ein Legendenfeld 35 angezeigt. In dem Darstellungsfeld 31 werden zeitliche Verläufe 37 bis 40 der Trace-Signale beispielsweise in einem Koordinatensystem dargestellt, dessen horizontale Koordinatenachse eine Zeit-Achse ist. Dabei können die zeitlichen Verläufe 37 bis 40 verschiedenartiger Trace-Signale gemeinsam dargestellt werden, wobei die zeitlichen Verläufe 37 bis 40 verschiedenartiger Trace-Signale verschiedenfarbig dargestellt sind. Die Menüleiste 33 weist verschiedene Schaltflächen auf, über die die Darstellung der zeitlichen Verläufe 37 bis 40 der Trace-Signale veränderbar ist. Beispielsweise weist die Menüleiste 33 Schaltflächen zum Zoomen der Darstellung oder zum horizontalen oder vertikalen Verschieben oder Skalieren einzelner zeitlicher Verläufe 37 bis 40 der Trace-Signale auf. Das Legendenfeld 35 weist für jeden in dem Darstellungsfeld 31 gezeigten zeitlichen Verlauf 37 bis 40 von Trace-Signalen einen Legendeneintrag 41 auf, der beispielsweise die Farbe und den Parameter des jeweiligen zeitlichen Verlaufs 37 bis 40 angibt. Ferner kann jeder Legendeneintrag 41 beispielsweise eine Schaltfläche aufweisen oder als eine Schaltfläche ausgeführt sein, über die in dem Darstellungsfeld 31 beispielsweise der zugehörige zeitliche Verlauf 37 bis 40 hervorhebbar ist und/oder eine vertikale Koordinatenachse mit den Einheiten der jeweiligen Trace-Signale einblendbar ist.

## Patentansprüche

1. Stromrichter (3), umfassend
- ein Tracemodul (7), das eingerichtet ist, Trace-Signale gemäß einer Trace-Konfiguration aufzuzeichnen,
- eine Speichereinheit (9), die eingerichtet ist, von dem Tracemodul (7) aufgezeichnete Trace-Signale zu speichern, und **gekennzeichnet durch**
- einen Webserver (5), der eingerichtet ist, die Erstellung der Trace-Konfiguration über einen Web-Client (13) zu ermöglichen und dem Web-Client (13) die von der Speichereinheit (9) gespeicherten Trace-Signale bereitzustellen,
- wobei die Trace-Konfiguration für jede Art aufzuzeichnender Trace-Signale eine Abtastrate für die Aufzeichnung der Trace-Signale spezifiziert.

2. Stromrichter (3) nach Anspruch 1, wobei der Webserver (5) eingerichtet ist, Presets für verschiedene Trace-Konfigurationen bereitzustellen, die über den Web-Client (13) auswählbar sind.

3. Stromrichter (3) nach Anspruch 2, wobei eine Auswahl von Parametern eines von dem Webserver (5) bereitgestellten Presets über den Web-Client (13) änderbar ist.

4. Stromrichter (3) nach einem der vorhergehenden Ansprüche, wobei der Webserver (5) eingerichtet ist, die Trace-Konfiguration zu exportieren.

5. Stromrichter (3) nach einem der vorhergehenden Ansprüche, wobei der Webserver (5) eingerichtet ist, eine Trace-Konfiguration und/oder ein Preset zu importieren.

6. Stromrichter (3) nach einem der vorhergehenden Ansprüche, wobei die Trace-Konfiguration die aufzuzeichnenden Trace-Signale und eine Triggerbedingung für den Beginn der Aufzeichnung der Trace-Signale spezifiziert.

7. Stromrichter (3) nach Anspruch 6 mit einem Kurzzeitspeicher (11), in dem von dem Tracemodul (7) aufgezeichnete Trace-Signale fortlaufend kurzzeitig gespeichert werden, wobei in der Trace-Konfiguration spezifizierte Trace-Signale, die während einer in der Trace-Konfiguration vorgebbaren Pretrigger-Zeitdauer vor dem Eintreten der Triggerbedingung in dem Kurzzeitspeicher (11) gespeichert wurden, mit der Speichereinheit (9) zusätzlich zu den ab Eintreten der Triggerbedingung gemäß der Trace-Konfiguration aufzuzeichnenden Trace-Signalen gespeichert werden.

8. Stromrichter (3) nach einem der vorhergehenden Ansprüche, wobei die Trace-Konfiguration eine Aufzeichnungsdauer der Aufzeichnung der Trace-Signale spezifiziert.

9. Tracesystem (1) zum Erfassen und Auswerten von Trace-Signalen eines Stromrichters (3), das Tracesystem (1) umfassend
- ein in den Stromrichter (3) integriertes Tracemodul (7), das eingerichtet ist, Trace-Signale gemäß einer Trace-Konfiguration aufzuzeichnen,
- eine in den Stromrichter (3) integrierte Speichereinheit (9), die eingerichtet ist, von dem Tracemodul (7) aufgezeichnete Trace-Signale zu speichern,
**gekennzeichnet durch**
- einen in den Stromrichter (3) integrierten Webserver (5) und
- einen Web-Client (13), wobei
- der Webserver (5) eingerichtet ist, die Erstellung der Trace-Konfiguration über den Web-Client (13) zu ermöglichen und dem Web-Client (13) die von der Speichereinheit (9) gespeicherten Trace-Signale bereitzustellen,
- der Web-Client (13) eine grafische Benutzerschnittstelle zum Erstellen der Trace-Konfiguration und zum grafischen Darstellen der Trace-Signale bereitstellt,
- und die Trace-Konfiguration für jede Art aufzuzeichnender Trace-Signale eine Abtastrate für die Aufzeichnung der Trace-Signale spezifiziert.

10. Tracesystem (1) nach Anspruch 9, wobei der Web-Client (13) eingerichtet ist, zeitliche Verläufe (37 bis 40) der von dem Tracemodul (7) aufgezeichneten Trace-Signale grafisch darzustellen.

11. Tracesystem (1) nach Anspruch 10, wobei der Web-Client (13) eingerichtet ist, zeitliche Verläufe (37 bis 40) verschiedenartiger von dem Tracemodul (7) aufgezeichneter Trace-Signale gemeinsam grafisch darzustellen.

12. Tracesystem (1) nach Anspruch 10 oder 11, wobei der Web-Client (13) eingerichtet ist, zeitliche Verläufe (37 bis 40) verschiedenartiger Trace-Signale verschiedenfarbig darzustellen.

13. Tracesystem (1) nach einem der Ansprüche 10 bis 12, wobei der Web-Client (13) Änderungen der grafischen Darstellung zeitlicher Verläufe (37 bis 40) verschiedenartiger Trace-Signale unabhängig voneinander durch horizontale und/oder vertikale Verschiebungen und/oder durch Skalierungen zu ermöglicht.

14. Tracesystem (1) nach einem der Ansprüche 10 bis 13, wobei der Web-Client (13) die Einblendung horizontaler und/oder vertikaler Mess-Cursor in die grafische Darstellung zeitlicher Verläufe (37 bis 40) der Trace-Signale ermöglicht.

15. Tracesystem (1) nach einem der Ansprüche 9 bis 14, wobei aufgezeichnete Trace-Signale und/oder deren grafische Darstellung vom Web-Client (13) exportierbar sind.

## Claims

1. Power converter (3), comprising
- a trace module (7) that is configured to record trace signals in accordance with a trace configuration,
- a storage unit (9) that is configured to store trace signals recorded by the trace module (7), and
- a web server (5) that is configured to enable the creation of the trace configuration via a web client (13) and to provide the trace signals stored by the storage unit (9) to the web client (13),
- wherein the trace configuration specifies, for each type of trace signal to be recorded, a sampling rate for the recording of the trace signals.

2. Power converter (3) according to claim 1, wherein the web server (5) is configured to provide presets for different trace configurations which are able to be selected via the web client (13).

3. Power converter (3) according to claim 2, wherein a selection of parameters of a preset provided by the web server (5) can be amended via the web client (13).

4. Power converter (3) according to one of the preceding claims, wherein the web server (5) is configured to export the trace configuration.

5. Power converter (3) according to one of the preceding claims, wherein the web server (5) is configured to import a trace configuration and/or a preset.

6. Power converter (3) according to one of the preceding claims, wherein the trace configuration specifies the trace signals that are to be recorded and a trigger condition for the start of the recording of the trace signals.

7. Power converter (3) according to claim 6 with a short-term memory store (11) in which trace signals recorded by the trace module (7) are continuously temporarily stored, wherein trace signals specified in the trace configuration which have been stored, before the occurrence of the trigger condition, in the short-term memory store (11) during a pre-trigger time period which is able to be specified in the trace configuration, are stored with the storage unit (9) in addition to the trace signals that are to be recorded in accordance with the trace configuration from the occurrence of the trigger condition.

8. Power converter (3) according to one of the preceding claims, wherein the trace configuration specifies a recording duration of the recording of the trace signals.

9. Trace system (1) for capturing and evaluating trace signals of a power converter (3), the trace system (1) comprising
- a trace module (7) that is integrated into the power converter (3) and is configured to record trace signals in accordance with a trace configuration,
- a storage unit (9) that is integrated into the power converter (3) and is configured to store trace signals recorded by the trace module (7),
- a web server (5) that is integrated into the power converter (3), and
- a web client (13), wherein
- the web server (5) is configured to enable the creation of the trace configuration via the web client (13) and to provide the trace signals stored by the storage unit (9) to the web client (13),
- the web client (13) provides a graphical user interface for creating the trace configuration and for graphical representation of the trace signals,
- and the trace configuration specifies, for each type of trace signal that is to be recorded, a sampling rate for the recording of the trace signals.

10. Trace system (1) according to claim 9, wherein the web client (13) is configured to graphically represent variations over time (37 to 40) of the trace signals recorded by the trace module (7).

11. Trace system (1) according to claim 10, wherein the web client (13) is configured to graphically represent together variations over time (37 to 40) of different types of trace signals recorded by the trace module (7).

12. Trace system (1) according to claim 10 or 11, wherein the web client (13) is configured to represent variations over time (37 to 40) of different types of trace signals in different colours.

13. Trace system (1) according to one of claims 10 to 12, wherein the web client (13) enables changes to the graphical representation of variations over time (37 to 40) of different types of trace signals independently of one another by way of horizontal and/or vertical displacements and/or by way of scalings.

14. Trace system (1) according to one of claims 10 to 13, wherein the web client (13) enables the superimposition of horizontal and/or vertical measuring cursors into the graphical representation of variations over time (37 to 40) of the trace signals.

15. Trace system (1) according to one of claims 9 to 14, wherein recorded trace signals and/or their graphical representation are able to be exported from the web client (13).

## Revendications

1. Convertisseur (3) de puissance, comprenant
- un module (7) de trace, qui est agencé pour enregistrer des signaux de trace suivant une configuration de trace,
- une unité (9) de mémoire, qui est agencée pour mettre en mémoire des signaux de trace enregistrés par le module (7) de trace, et
**caractérisé par**
- un serveur (5) toile, qui est agencé pour permettre l'établissement de la configuration de trace par l'intermédiaire d'un client (13) toile et pour mettre les signaux de trace mis en mémoire par l'unité (9) de mémoire à la disposition du client (13) toile,
- dans lequel la configuration de trace spécifie, pour chaque type de signaux de trace à enregistrer, un taux d'échantillonnage de l'enregistrement des signaux de trace.

2. Convertisseur (3) de puissance suivant la revendication 1, dans lequel le serveur (5) toile est agencé pour mettre des presets à disposition de diverses configurations de trace, qui peuvent être choisis par le client (13) toile.

3. Convertisseur (3) de puissance suivant la revendication 2, dans lequel une sélection de paramètres d'un preset mis à disposition par le serveur (5) toile peut être modifiée en passant par le client (13) toile.

4. Convertisseur (3) de puissance suivant l'une des revendications précédentes, dans lequel le serveur (5) toile est agencé pour exporter les configurations trace.

5. Convertisseur (3) de puissance suivant l'une des revendications précédentes, dans lequel le serveur (5) toile est agencé pour importer une configuration trace et/ou un preset.

6. Convertisseur (3) de puissance suivant l'une des revendications précédentes, **caractérisé en ce que** la configuration trace spécifie les signaux trace enregistrés et une condition de déclenchement du début de l'enregistrement des signaux trace.

7. Convertisseur (3) de puissance suivant la revendication 6, comprenant une mémoire (11) de courte durée, dans laquelle on met brièvement en mémoire en continu des signaux de trace enregistrés par le module (7) de trace, dans lequel on a mis en mémoire, supplémentairement aux signaux de trace à enregistrer suivant la configuration de trace à partir de l'apparition de la condition de déclenchement, par l'unité (9) de mémoire, les signaux de trace, qui sont spécifiés dans la configuration de trace et qui ont été mis en mémoire dans la mémoire (11) de courte durée avant l'apparition de la condition de déclenchement, pendant une durée de pré-déclenchement pouvant être donnée à l'avance dans la configuration de trace.

8. Convertisseur (3) de puissance suivant l'une des revendications précédentes, dans lequel la configuration de trace spécifie une durée d'enregistrement de l'enregistrement des signaux de trace.

9. Système (1) de trace pour la détection et l'évaluation de signaux de trace d'un convertisseur (3) de puissance, le système (1) de trace comprenant
- un module (7) de trace intégré au convertisseur (3) de puissance et agencé pour enregistrer des signaux de trace suivant une configuration de trace,
- une unité (9) de mémoire intégrée au convertisseur (3) de puissance et agencée pour mettre en mémoire des signaux de trace enregistrés par le module (7) de trace,
**caractérisé par**
- un serveur (5) toile intégré au convertisseur (3) de puissance et
- un client (13) toile, dans lequel
- le serveur (5) toile est agencé pour permettre l'établissement de la configuration de trace en passant par le client (13) toile et pour mettre à disposition du client (13) toile les signaux de trace mis en mémoire par l'unité (9) de mémoire,
- le client (13) toile met à disposition une interface utilisateur graphique pour l'établissement de la configuration de trace et pour la représentation graphique des signaux de trace,
- et la configuration de trace spécifie pour chaque type de signaux de trace à enregistrer un taux d'échantillonnage de l'enregistrement des signaux de trace.

10. Système (1) de trace suivant la revendication 9, dans lequel le client (13) toile est agencé pour représenter graphiquement des courbes (37 à 40), en fonction du temps, des signaux de trace enregistrés par le module (7) de trace.

11. Système (1) de trace suivant la revendication 10, dans lequel le client (13) toile est agencé pour représenter graphiquement conjointement des courbes (37 à 40), en fonction du temps, de divers signaux de trace de type différent enregistrés par le module (7) de trace.

12. Système (1) de trace suivant la revendication 10 ou 11, dans lequel le client (13) toile est agencé pour représenter en des couleurs différentes des courbes (37 à 40), en fonction du temps, de signaux de trace de types différents.

13. Système (1) de trace suivant l'une des revendications 10 à 12, dans lequel le client (13) toile rend possible, par des décalages horizontaux et/ou verticaux et/ou par des mises à l'échelle, des variations de la représentation graphique de courbes (37 à 40), en fonction du temps, de signaux de trace de types différents indépendamment les unes des autres.

14. Système (1) de trace suivant l'une des revendications 10 à 13, dans lequel le client (13) toile rend possible une incrustation de cursor de mesure horizontal et/ou vertical, dans la représentation graphique de courbes (37 à 40), en fonction du temps, des signaux de trace.

15. Système (1) de trace suivant l'une des revendications 9 à 14, dans lequel les signaux de trace enregistrés et/ou leurs représentations graphiques peuvent être exportés par le client (13) toile.
